# EUROPEAN PATENT APPLICATION

(11) **EP 4 513 198 A1**
(43) Date of publication of application: **26.02.2025**
(21) Application number: 23192309.5
(22) Date of filing: 21.08.2023
(51) Int. Cl.: G01P 1/02, H01L 23/31, H05K 3/30

(54) **ELECTRONIC COMPONENT, CIRCUIT BOARD AND METHOD**

(71) Applicant: Murata Manufacturing Co., Ltd., Nagaokakyo-shi, Kyoto 617-8555 (JP)
(72) Inventor: Nurmi, Sami, 04320 Tuusula (FI); Syrjänen, Teppo, 00400 Helsinki (FI)
(74) Representative: Boco IP Oy Ab

(57) **Abstract**

An electronic component (1) is configured to be mounted on an external surface (21), which surface (21) defines a plane (22). The electronic component (1) comprises at least one electronic chip (2) housed within package (3). The electronic component (1) is provided with one or more aligning structures (5), which aligning structure(s) (5) are formed on an outer surface (6) of the electronic component (1). The aligning structure(s) (5) define at least two first aligning surface areas (7) in a first direction (8) and at least two second aligning surface areas (9) in a second direction (10). The first aligning surface areas (7) and the second aligning surface areas (9) are formed and spaced from each other in such a manner that at least a rotation of the electronic component (1) about an axis (11) perpendicular to the plane (22) defined by the surface (21) is prevented, when the first aligning surface areas (7) and the second aligning surface areas (9) are provided against counter surfaces (23) fixed on the surface (21) and conforming at least partly to the form of the respective aligning surface areas (7, 9).

## Description

### FIELD OF THE DISCLOSURE

The present disclosure relates to electronic components, and particularly to electronic components where a die is protected by a surrounding package. The present disclosure further concerns the printed circuit board and a method for alignment of the package with a circuit board.

### BACKGROUND

Electronic dies, which may also be called chips, can be prepared by manufacturing electronic structures on a substrate and cutting the substrate into small pieces. The substrate may be a semiconductor substrate, for example a silicon substrate. Each die which is cut from the substrate may be placed inside a protective package by attaching it to a support structure and then building the package around it. The die can also be electrically connected to other chips inside the same package and/or to leads which extend to the outside of the package. The package and its contents can thereby form an electronic component which can be mounted on a circuit board. The circuit board can further be mounted on an apparatus, such as a vehicle, a machine or equipment or similar, depending on the application.

Some dies are orientation-sensitive and have to be carefully aligned inside the package to ensure that the output of the electronic component is accurate. Orientation-sensitive dies include for instance magnetometer dies and dies which measure inertial variables such as acceleration or angular velocity.

A problem related to such components is that the multi-phase mounting process includes many steps, which may cause inaccuracy in the direction of the die in relation to the circuit board and the apparatus. To compensate this, the alignment has to be calibrated in connection with the final phase mounting the circuit board to the apparatus, which takes time in the manufacturing process, and it is often necessary to rotate the circuit board with respect to the apparatus to align the die accurately with a direction of a desired measurement axis.

### BRIEF DESCRIPTION

An object of the present solution is to provide a new electronic component, a new circuit board and a new method for aligning an electronic component on the circuit board.

The object of the disclosure is achieved by an electronic component, a circuit board, and a method, which are characterized by what is stated in the independent claims. Some embodiments of the disclosure are disclosed in the dependent claims.

The disclosure is based on the idea of forming parts of an outer surface of the electronic component to enable accurate aligning of especially an axis of interest of a chip provided in the electronic component with a surface, on which the electronic component is designed to be provided on, such as the circuit board.

An advantage of the method and apparatus is that accuracy of the alignment between the axis of interest and the surface, on which the electronic component is provided on, can be significantly improved.

### BRIEF DESCRIPTION OF THE DRAWINGS

In the following the disclosure will be described in greater detail by means of preferred embodiments with reference to the accompanying drawings, in which
Figure 1 illustrates schematically an electronic component according to a first embodiment in cross section shown from the direction of a side of the electronic component;
Figure 2 illustrates schematically the electronic component of Figure 1 in cross section shown from a direction of an end of the electronic component;
Figure 3 illustrates schematically an electronic component, such as the electronic component of Figures 1 and 2, shown from a bottom of the electronic component;
Figure 4 illustrates schematically an electronic component according to a second embodiment in cross section shown from a direction of a side of the electronic component;
Figure 5 illustrates schematically the electronic component of Figure 4 in cross section shown from a direction of an end of the electronic component;
Figure 6 illustrates schematically an electronic component according to a third embodiment and a circuit board shown in cross section from a direction of a side of the electronic component;
Figure 7 illustrates schematically the electronic component and the circuit board of Figure 6 shown in cross section from a direction of an end of the electronic component;
Figure 8 illustrates schematically an electronic component, such as the electronic component of Figures 6 and 7, and a circuit board shown from above the electronic component;
Figure 9 illustrates schematically an electronic component according to a fourth embodiment, a circuit board and a module in cross section shown from the direction of a side of the electronic component;
Figure 10 illustrates schematically an electronic component according to a fifth embodiment in cross section and a circuit board shown from the direction of a side of the electronic component;
Figure 11 illustrates schematically an electronic component, such as the electronic component of Figure 10, and a circuit board shown from above the electronic component; and
Figure 12 illustrates schematically a method for aligning an electronic component.

The figures are provided for schematically illustrating features of the solution only. The figures do not show all the features of the objects and are not shown to scale.

### DETAILED DESCRIPTION

The description relates to electronic components, and particularly to electronic components where a die, also called a chip, is protected by a surrounding package. The description further concerns the printed circuit board and a method for alignment of the package with a circuit board, also called a printed circuit board (PCB).

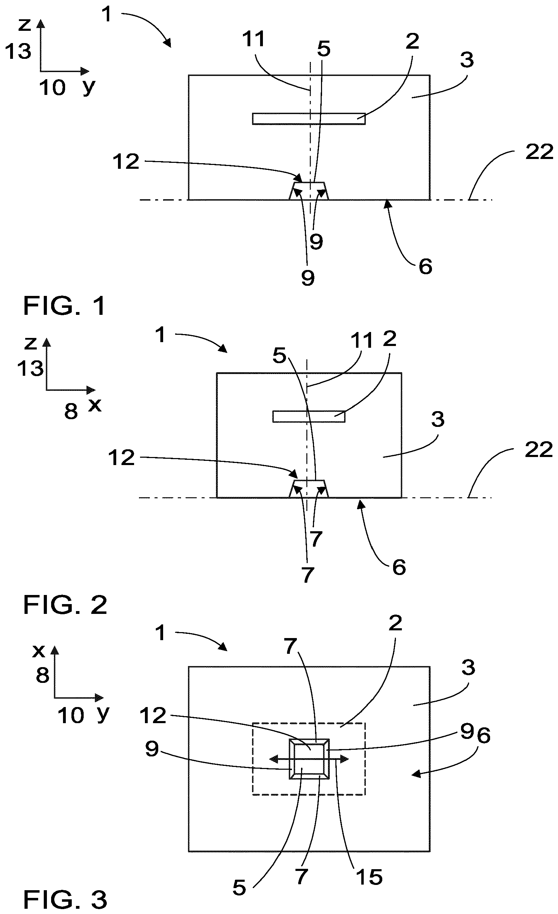

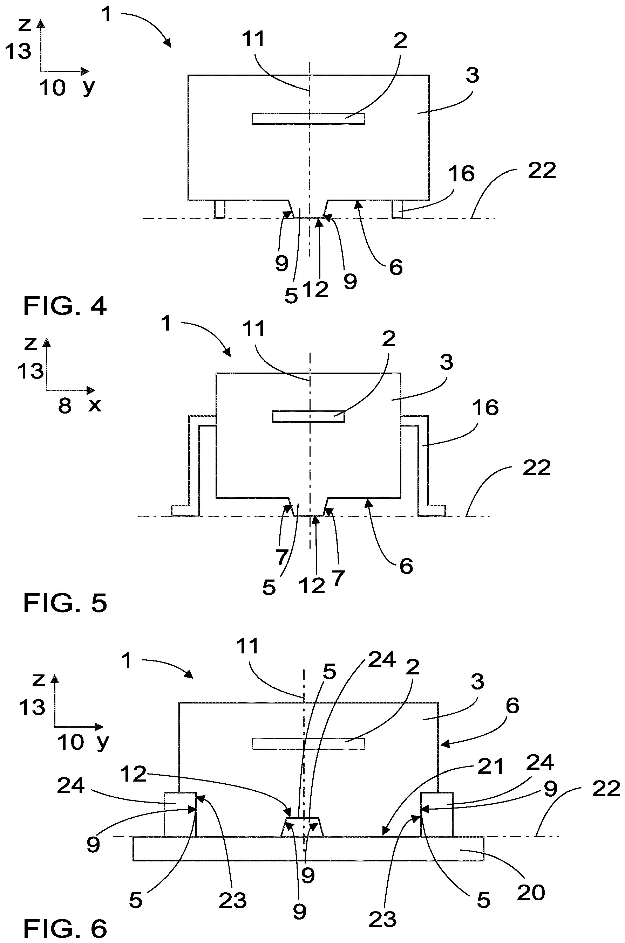

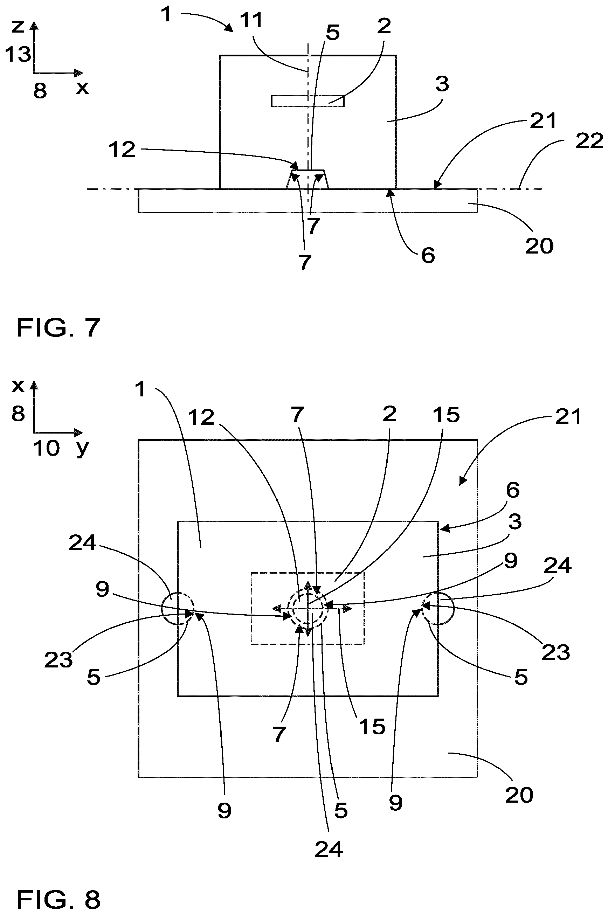

Figures 1 - 11 disclose some embodiments of electronic components 1. For example, Figure 1 illustrates schematically an electronic component according to a first embodiment in cross section shown from the direction of a side of the electronic component; Figure 2 illustrates schematically the electronic component of Figure 1 in cross section shown from a direction of an end of the electronic component; Figure 3 illustrates schematically an electronic component, such as the electronic component of Figures 1 and 2, shown from a bottom of the electronic component; Figure 4 illustrates schematically an electronic component according to a second embodiment in cross section shown from a direction of a side of the electronic component; Figure 5 illustrates schematically the electronic component of Figure 4 in cross section shown from a direction of an end of the electronic component; Figure 6 illustrates schematically an electronic component according to a third embodiment and a circuit board shown in cross section from a direction of a side of the electronic component; Figure 7 illustrates schematically the electronic component and the circuit board of Figure 6 shown in cross section from a direction of an end of the electronic component; and Figure 8 illustrates schematically an electronic component, such as the electronic component of Figures 6 and 7, and a circuit board shown from above the electronic component.

For the sake of clarity, in the figures of this disclosure, shapes of the parts have been simplified and the electronic components, for example, are mostly illustrated as rectangular blocks with straight edges extending parallel to the x-axis and the y-axis. The electronic component is then assumed to be oriented correctly when the four edges of the electronic component are parallel to the four edges of the surface, on which the electronic component is configured to be mounted to. However, the parts shown, such as the electronic component, the chip and circuit board could in reality have more complicated shapes than the figures of this disclosure illustrate. The chip may for example have the shape of a polygon with straight edges which form the sides of the chip.

The general principles of alignment are, however, the same regardless of the shape of the electronic component, the circuit board and so on. When the directional alignment of the electronic component is correct, possible orientation-sensitive axis/axes in the electronic component and the chip are oriented correctly with respect to a predetermined direction on the horizontal surface the electronic component is configured to be mounted to, such as the surface of the circuit board. Similarly, when the positional alignment of the component is correct, the location of every part of the component with respect to a predetermined point on the surface is correct. As described in more detail below, the alignment arrangements described in this disclosure are primarily focused on directional alignment. When the directional alignment of the electronic component comprising an orientation-sensitive chip is correct, an output of the electronic component will accurately reflect the orientation of the circuit board in the apparatus, or a module 25 of the apparatus, to which it is mounted to. Also positional alignment may be important in some applications, and some embodiments described in this disclosure may also provide positional alignment.

An electronic component 1, such as an electronic component according to one or more of Figures 1 - 11, is configured to be mounted on an external surface 21. The surface 21 being external refers to the surface 21 being a surface of a part separate from the electronic component 1. In other words, the electronic component 1 is designed to be provided on the surface 21 and to be attached to the surface 21.

The surface 21 defines a plane 22, onto which the electronic component 1 is configured to be mounted. In other words, the electronic component 1 and the structural parts of the electronic component 1 are designed to have a predetermined alignment with respect to the plane 22. The electronic component 1 may also have a predetermined position with respect to the plane 22. The electronic component 1 may be mounted, directly or indirectly via fastening means, to the surface 21.

The part of the electronic component 1 directed, or configured to be directed, when the electronic component 1 is mounted to the surface 21, towards the surface 21 is called bottom of the electronic component 1 in this disclosure, regardless of the actual direction of the electronic component 1 and the surface 21, when the electronic component 1 is mounted to an apparatus.

The plane 22, namely the plane 22 defined by the surface 21, is illustrated as the xy-plane in this disclosure. This plane 22 can also be considered a horizontal plane in this disclosure. Similarly, a vertical direction is indicated with a z-axis. The term "horizontal" refers in this disclosure to directions which are parallel to the xy-plane. In this disclosure, terms such as "vertical", "top", "bottom", "up", "down", "below" and "above" refer to the direction which is perpendicular to the xy-plane and to relative positions and distances in that direction. These terms do not indicate anything about how the component should be oriented with regard to the Earth's gravitational field when the component is manufactured, mounted, or when it is being used.

In this disclosure, an "end" of the electronic component 1 is an outer surface of the electronic component 1, which extends in a first direction 8, which is the direction of the x-axis, as seen in the figures, and in a third direction 13, which is the direction of the z-axis. In other words, the end of the electronic component 1 extends in a vertical direction from the surface 21, when the electronic component 1 is placed on the surface 21. The electronic component 1 may be considered to have two ends, which are opposite to each other in a horizontal direction.

In this disclosure, a "side" of the electronic component 1 is an outer surface of the electronic component 1, which extends in a second direction 10, which is the direction of the y-axis, as seen in the figures, and in the third direction 13, which is the direction of the z-axis. In other words, the side of the electronic component 1 extends in a vertical direction from the surface 21, when the electronic component 1 is placed on the surface 21. The electronic component 1 may be considered to have two sides, which are opposite to each other in a horizontal direction. In this disclosure, a side of the electronic component 1 is considered to have a longer length in the horizontal direction than an end of the electronic component, if these dimensions are different from each other, but there is no functional difference between a side and an end, and these terms are used for explaining relative positions of features and references to figures only.

In this disclosure, the word "length" is used as a general term for a distance measure, or dimension, in the horizontal plane. Lengths can for example be measured in the direction of the x-axis, or in the direction of the y-axis, or in any other direction in the xy-plane. The ends and sides of the electronic component 1 are mostly illustrated as straight structures in the figures of this disclosure for clarity, whereby the corresponding lengths are linear measures. However, the shape of the electronic components 1 and their structural parts, such as the package 3 or a cap 14, may vary in actual applications, and at least some of the outer surfaces 6 of the electronic components 1 may be angled and/or curved.

The electronic component 1 also has a top surface and a bottom surface, which extend in the direction of the plane 22, namely in the direction of the xy-plane, which is substantially horizontal when the electronic component 1 is placed on the surface 21, and which are provided opposite to each other in the vertical direction.

The electronic component 1 comprises at least one electronic chip 2. In the electronic component 1, the electronic chip 2 is housed within package 3. The package 3 provides protection for the chip(s) 2 inside the electronic component 1. According to an embodiment, the package 3 may be made of one material. According to another embodiment, the package 3 may comprise multiple materials, for instance some part(s) of the package 3 may be made of one material and some other part(s) of the package 3 from another material. According to an embodiment, the package 3, and thus the electronic component 1, may comprise a cap 14. The cap 14 may be made of a material different from the material of the rest of the package 3. According to an embodiment, the package 3 may comprise at least one of the following: a plastic material, a metal material, or a ceramic material. According to an embodiment, the cap 14 may comprise at least one of the following: a metal material or a ceramic material.

The electronic component 1, such as an electronic component according to one or more of Figures 1 - 11, is provided with one or more aligning structures 5. The aligning structure(s) 5 are formed on an outer surface 6 of the electronic component 1. The aligning structure(s) 5 define at least two first aligning surface areas 7 in a first direction 8 and at least two second aligning surface areas 9 in a second direction 10. The first direction 8 and the second direction 10 are parallel to the plane 22 defined by the surface 21 and perpendicular in relation to each other. According to an embodiment, the first direction 8 is parallel to the x-axis and the second direction 10 is parallel to the y-axis, as defined in this disclosure.

In this disclosure, an aligning surface area, such as a first aligning surface area 7, a second aligning surface area 9 or a further aligning surface area presented in this disclosure, may comprise a whole continuous surface area, such as a surface area limited by folds, corners and/or turns in the surface, or it may comprise a part of such a continuous surface area, in other words a partial surface area. For instance, according to an embodiment, an aligning structure 5 may comprise a hemispherical surface may comprise partial surface areas in the direction of x-axis, y-axis and y-axis, whereby it may form aligning surface areas in the first direction 8, the second direction 10 and also in a third direction 13 perpendicular to the first direction 8 and the second direction 10. Thus, the first aligning surface areas 7 may be provided on opposite sides of the aligning structure 5 in the first direction 8, the second aligning surface areas 9 may be provided at opposite ends of the aligning structure 5, and so on.

In the electronic component 1, such as an electronic component 1 according to one or more of Figures 1 - 11, the first aligning surface areas 7 and the second aligning surface areas 9 are formed and spaced from each other in such a manner that at least a rotation of the electronic component 1 about an axis 11 perpendicular to the plane 22 defined by the surface 21 is prevented, when the first aligning surface areas 7 and the second aligning surface areas 9 are provided against counter surfaces 23 fixed on the surface 21 and conforming at least partly to the form of the respective aligning surface areas 7, 9. In other words, the first aligning surface areas 7 and the second aligning surface areas 9 have such a shape and mutual position that rotation about the axis 11 can be prevented by using the first aligning surface areas 7 and the second aligning surface areas 9 for the aligning. The first aligning surface areas 7 and the second aligning surface areas 9 may be used for aligning by providing the surface 21 with counter surfaces 23 conforming at least partly, preferably over the whole surface area designed to engage with the respective aligning surface area 7, 9, and positioning the counter surfaces 23 in such a manner that providing the electronic component on the surface 21 and bringing each one of the aligning surface areas 7, 9 and a corresponding counter surface 23 into contact with each other, the electronic component 1 is brought to a predetermined alignment with respect to the surface 21.

The axis 11 may comprise an axis parallel with the y-axis, as defined in this disclosure. The axis 11 is perpendicular to the first direction 8 and the second direction 10.

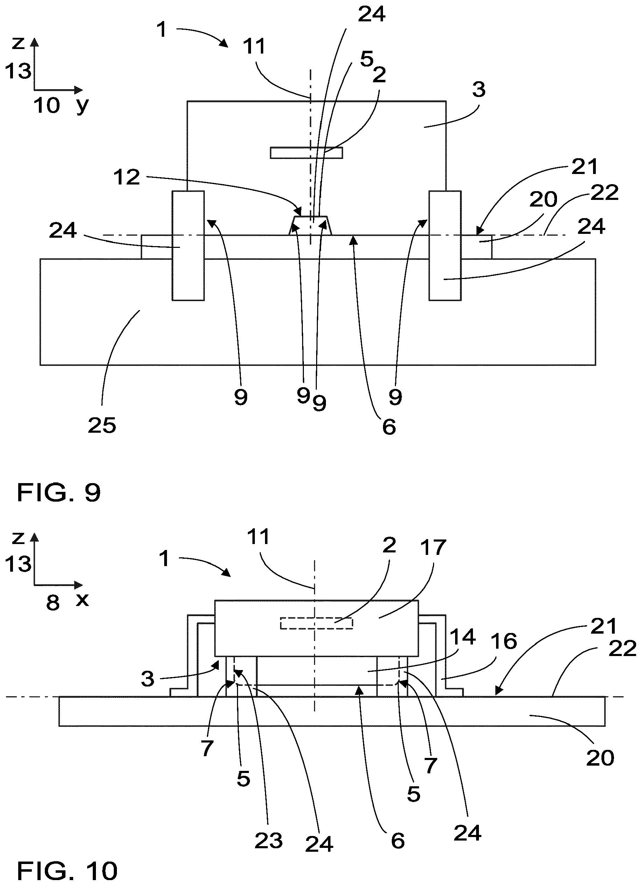

According to an embodiment, the first aligning surface areas 7 and the second aligning surface areas 9 are configured to have such a shape and mutual position that rotation about the axis 11 can be prevented by using the first aligning surface areas 7 and the second aligning surface areas 9 for the aligning in such a manner that the electronic component 1 has at least one aligning structure 5 and the shape of the aligning structure 5 is different from a body of revolution relative to the axis 11. Thereby, the shape of the aligning structure 5, and thus the shape of the aligning surface areas 7, 9, may be used to align the electronic component 1 on the surface 21 and to prevent its rotation about the axis 11. According to another embodiment, the first aligning surface areas 7 and the second aligning surface areas 9 may be configured to have such a shape and mutual position that rotation about the axis 11 can be prevented by using the first aligning surface areas 7 and the second aligning surface areas 9 for the aligning in such a manner that the electronic component 1 has one or more aligning structures 5 having a shape of a body of revolution relative to the axis 11 and that the electronic component 1 has in total at least two aligning structures 5 spaced from each other. Thereby, the position of the aligning structures 5, and thus the position of the aligning surface areas 7, 9, may be used to align the electronic component 1 on the surface 21 and to prevent rotation about the axis 11. Spacing, in each direction, the aligning surface areas 7, 9, 12 from each other improves accuracy of alignment, as manufacturing tolerances have a smaller effect. More particularly, the further the aligning surface areas 7, 9, 12 are provided from each other, the better the accuracy of alignment. According to an embodiment, the second aligning surface areas 12 may be provided at opposite ends of the electronic component, such as shown in the Figures 8 and 9.

According to an embodiment, at least one aligning structure 5 is provided in a middle of the bottom of the electronic component 1, or at least in a middle area of the bottom of the electronic component 1.

According to an embodiment, the aligning structure(s) 5 further define at least two third aligning surface areas 12 in the third direction 13. As described above, the third direction 13 is perpendicular to the first direction 8 and the second direction 10, as well as to the plane 22 defined by the surface 21, on which the electronic component 1 is configured to be mounted on. According to an embodiment, the third aligning surface areas 12 are configured to have such a shape and mutual position that the position of the electronic component 1 in the third direction 13 can be defined by the third aligning surface areas 12. According to an embodiment, the third aligning surface areas 12 are configured to have such a shape and mutual position that, together with the first aligning surface areas 7 and/or the second aligning surface areas 9, a rotation of the electronic component 1 about an axis parallel to the second direction 10, or the y-axis, and/or a rotation of the electronic component 1 about an axis parallel to the first direction 8, or the x-axis, respectively, can be prevented by using the first aligning surface areas 7 and third aligning surface areas 12 and/or the second aligning surface areas 9 and the third aligning surface areas 12, respectively. The third aligning surface areas 12 may be used for aligning the electronic component 1 on the surface 21 in a manner corresponding to that disclosed in connection with the first aligning surface areas 7 and the second aligning surface areas 9.

According to an embodiment, the electronic component 1 comprises exactly one aligning structure 5. According to an embodiment, the electronic component 1 comprises exactly one aligning structure 5 and each one of the first aligning surface areas 7, the second aligning surface areas 9 and/or the third aligning surface areas 12 comprises a part of the outer surface 6 of the electronic component 1 in the area of the aligning structure 5. In other words, the first aligning surface areas 7, the second aligning surface areas 9 and/or the third aligning surface areas 12 are provided along the outer surface of the aligning structure 5. In such embodiments, as described above, the aligning structure 5 comprises a shape different from a body of revolution about the axis 11 parallel with the third direction 13.

According to an embodiment, the electronic component 1 comprises at least two aligning structures 5 and each one of the first aligning surface areas 7, the second aligning surface areas 9 and/or the third aligning surface areas 12 comprises in each case a part of the outer surface 6 of the electronic component in the area of one of the aligning structures 5. In other words, all the aligning surface areas 7, 9, 12 may be provided on a surface of a same aligning structure 5, at least one of the aligning surface areas 7, 9, 12 may be provided on a surface of another aligning structure 5, some of the aligning surface areas 7, 9, 12 may be provided on a surface of different aligning structures 5, or all aligning surface areas 7, 9, 12 may be provided on a surface of different aligning structures 5, depending on the embodiment.

According to an embodiment, each aligning surface area 7, 9, 12 has a precise, predetermined three-dimensional shape. Thereby the aligning surface areas 7, 9, 12 form in each case a pair of aligning surface areas 7, 9, 12 in the respective direction 8, 10, 13 in such a manner that the electronic component 1 can be precisely aligned in each of the directions with respect to the surface 2, when the aligning surface areas 7, 9, 12 are provided against respective counter surfaces 23 fixed to the surface 21. Aligning the electronic component 1 precisely refers to aligning the electronic component 1 at an accuracy of at least 0.1 degrees at least in the first direction 8 and in the second direction 10, preferably in any direction. In other words, aligning the electronic component 1 precisely refers to aligning the electronic component 1 at an alignment inaccuracy of 0.1 degrees or less at least in the first direction 8 and in the second direction 10, preferably in any direction.

According to an embodiment, at least one aligning structure 5 is formed as a protrusion protruding from the outer surface 6 or a recess extending from the outer surface 6 into the electronic component 1. Depending on the embodiment, the aligning structure 5 may protrude or recess with respect to outer surface 6 of the electronic component 1 the surrounding the aligning structure 5. According to an embodiment, the aligning structure 5 may also have both protruding and recessed portions.

According to an embodiment, at least one aligning structure 5 is formed as a section of a cylinder, a section of a cone, a pyramid, a section of a pyramid, a cut pyramid, a section of a cut pyramid, a section of a sphere, an ellipsoid dome, a cube, a cuboid, a prism or a cut triangular prism. According to an embodiment, a part of at least one aligning structure may be formed as a section of a cylinder, a section of a cone, a pyramid, a section of a pyramid, a cut pyramid, a section of a cut pyramid, a section of a sphere, an ellipsoid dome, a cube, a cuboid, a prism or a cut triangular prism. According to a further embodiment, at least one aligning structure 5 may have any two-dimensional or three-dimensional shape that enables, for its part, aligning the electronic component 1 on the surface 21, as disclosed in this disclosure.

According to an embodiment, at least one of the first aligning surface areas 7, the second aligning surface areas 9 or the third aligning surface areas 12 has a three-dimensional shape. In other words, at least one of the aligning surface areas 7, 9, 12 may extend in all three dimensions.

According to an embodiment, the aligning structure(s) 5 are provided in a part of the electronic component (1) made from a dimension accurate material. A dimension accurate material refers to a material that is dimension tolerant and dimensionally stable, at least dimension tolerant and dimensionally stable in normal manufacturing and use conditions. Thereby, a position of the aligning structure 5, and especially the aligning surface areas 7, 9, 12, is known relative to the chip 2, preferably known with a measurement inaccuracy of 0.1 degrees or smaller. According to an embodiment, the aligning structure(s) 5 are provided in a part of the electronic component 1 made from metal, ceramic material or a plastic material. According to an embodiment, the metal material may comprise stainless steel, copper, or nickel-cobalt ferrous alloy, such as Kovar. Providing the aligning structure(s) 5 in such a part of the electronic component made from a dimension accurate material accuracy of the alignment electronic component can be significantly improved.

According to an embodiment, the electronic component 1 further comprises a cap 14. Such caps 14 are known in the art and the cap 14 may cover for instance a top or a bottom of the package 3 and, thus, the electronic component 1. According to such an embodiment, at least one of the aligning structures 5 may be provided in the cap 14.

According to an embodiment, the at least one chip 2 may be separated from the cap 14 by a gap and the cap 14 may be attached to a package base 17 to form an enclosure. According to an embodiment, the bottom surface of the cap 14 may be configured to be parallel to the plane of the circuit board, or a circuit board plane. The gap may comprise for instance an air gap.

According to an embodiment, the cap may be formed from a metal, such as stainless steel, copper, or nickel-cobalt ferrous alloy, such as Kovar, and so on.

According to an embodiment, the package base 17 may for instance be made of plastic. According to an embodiment, the package base 17 may be manufactured in a moulding process where the package base 17 is moulded around a leadframe, where a chip mounting element (not shown) and/or electronic leads 16 have been formed. Other methods can also be used to form a plastic package base 17. The package base 17 may alternatively be made of a ceramic material. The cap 14 can be attached to the package base 17 with glue or with any other method. The attachment region where the cap 14 is attached to the package base 17 may encircle the enclosure.

According to an embodiment, the electronic chip 2 is orientation-sensitive. According to an embodiment, the electronic component 1, such as the chip 2, may comprise an axis of interest 15. The axis of interest 15 may be an orientation-sensitive axis. In other words, the chip 2 may comprise an axis of interest 15, the alignment of which in relation to the surface 21, to which the electronic component 1 is configured to be mounted, or an apparatus, where a module comprising the surface 21 is configured to be mounted to, is relevant for the purpose of the electronic component 1. According to an embodiment, the orientation-sensitive electronic chip 2 comprises the axis of interest 15, and the aligning surface areas 7, 9, 12 are configured to align at least the axis of interest 15 with respect to the surface 21. According to an embodiment, the axis of interest 15 may be associated with a function configured to be monitored using the electronic component 1.

According to an embodiment, the electronic chip 2 comprises at least one of the following: an accelerometer configured to measure acceleration, a gyroscope configured to measure angular rotation, or a magnetometer. The accelerometer or gyroscope may be a MEMS accelerometer / gyroscope. According to an embodiment, the electronic chip 2 comprises another type of an orientation-sensitive chip.

According to an embodiment, the one or more aligning structures 5 provided in the electronic component 1 define at least two aligning surface areas 7, 9, 12 in the direction of each one of the three dimensions in such a manner that they enable aligning the electronic component 1 to in all three dimensions with respect to the surface 21 comprising respective counter surfaces 23. According to an embodiment, the aligning structure(s) 5 may be configured to define the alignment of the electronic component 1 on the surface 21 in such a manner that rotation of the electronic component 1 about axes parallel to all three axes, namely parallel to the first direction 8, the second direction 10 and the third direction 13, is prevented. According to an embodiment, the aligning structure(s) 5 may be configured, in addition to preventing the rotation of the electronic component 1, to define the position of the electronic component 1 on the surface 21 in all three dimensions, namely in the first direction 8, the second direction 10 and the third direction 13.

According to an embodiment, aligning the electronic component 1 on the surface 21 comprises aligning at least one predetermined axis of the electronic component 1, namely an axis of interest 15, in relation to a predetermined direction, such as the first direction 8, the second direction 10 and/or the third direction 13. According to an embodiment, aligning the electronic component 1 on the surface 21 comprises aligning the axis of interest 15 in relation to the first direction 8 or the second direction 10. According to an embodiment, aligning the electronic component 1 on the surface 21 comprises preventing rotation about an axis parallel to the third direction 13, which direction is also called the direction of the z-axis in this disclosure.

It is clear for a person skilled in the art that aligning the electronic component 1, as disclosed in this disclosure, also aligns the chip 2 and the possible axis of interest 15, as long as the alignment of the chip 2 and the possible axis of interest 15, respectively, in relation to the electronic component 1 is also known. The ways of aligning the chip 2 and/or the axis of interest 15 in relation to the electronic component 1 are not in the scope of this disclosure.

According to an embodiment, the package 3 may further comprise a plurality of electronic leads 16 protruding from the package 3. The leads 16 may be configured to extend from at least two sides of the package 3, preferably from at least two opposite sides of the package 3, as seen in Figures 4-5 and 10 - 11, from a top part of the package 3 towards the surface 21 at least in the third direction 13. In other words, the electronic leads 16 may be configured to protrude from the package 3 at least in a direction corresponding to a downward direction. According to an embodiment, the electronic leads 16 may further be configured to extend outwards from the package 3, for instance in a bended manner, such as seen in Figures 4-5 and 10 - 11.

The electronic component may further comprise further external contacts and mounting elements which allow the component to be attached and electrically connected to the surface 21, such as a surface of a circuit board 20.

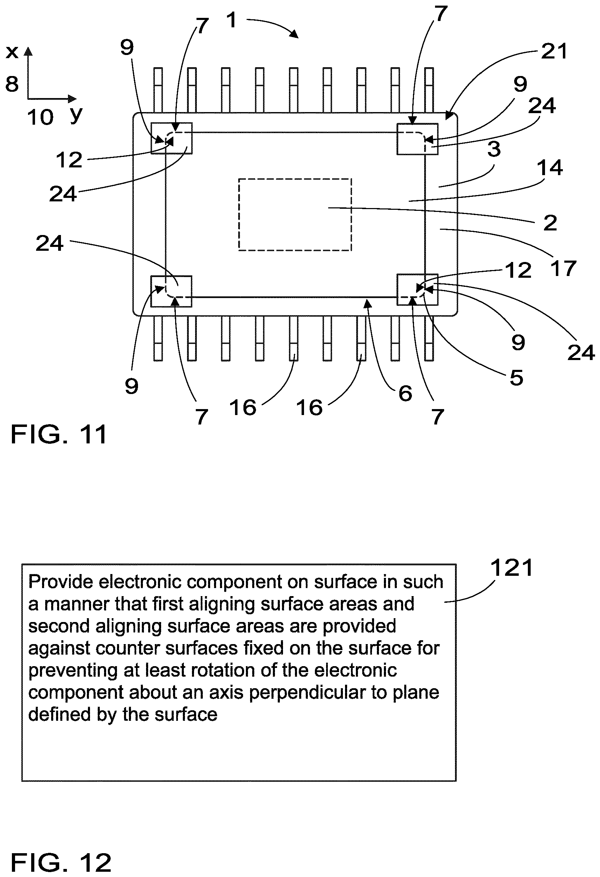

Figure 9 illustrates schematically an electronic component according to a fourth embodiment, a circuit board and a module in cross section shown from the direction of a side of the electronic component; Figure 10 illustrates schematically an electronic component according to a fifth embodiment in cross section and a circuit board shown from the direction of a side of the electronic component; and Figure 11 illustrates schematically an electronic component, such as the electronic component of Figure 10, and a circuit board shown from above the electronic component. Also Figures 6 - 8 illustrate electronic components provided on circuit boards.

According to an embodiment, a circuit board 20 may be configured to receive an electronic component 1 according to an embodiment or a combination of embodiments disclosed in this disclosure. According to an embodiment, the surface 21 of the circuit board 20 configured to receive the electronic component 1 comprises the surface 21, on to which the electronic component 1 is configured to be mounted to, and the surface 21 of the circuit board 20 defines the plane 22 referred to in connection with the embodiments of the electronic component 1. According to an embodiment, such a circuit board 20 comprises an electronic component 1 according to an embodiment or a combination of embodiments disclosed in this disclosure mounted on the surface 21 of the circuit board 20.

According to an embodiment, the surface 21, which in this embodiment is thus the surface of the circuit board, is provided with at least one aligning counter structure 24. The aligning counter structure(s) 24 or parts of the aligning counter structure(s) 24 may comprise counter surfaces 23 conforming at least partly to the form of the respective aligning surface areas 7, 9 in the electronic component 1 for aligning the electronic component 1 on the circuit board 20. According to an embodiment, the counter surfaces 23 conform to the form of the respective aligning surface areas 7, 9 in the electronic component 1 over the whole surface area designed to engage with the respective aligning surface area 7, 9. The counter surfaces 23 are preferably positioned in such a manner that providing the electronic component 1 on the surface 21 and bringing each one of the aligning surface areas 7, 9 and a corresponding counter surface 23 into contact with each other, the electronic component 1 is brought to a predetermined alignment with respect to the surface 21 on the circuit board 20.

According to an embodiment, such as an embodiment of Figures 10 and 11, the aligning structure 5 may be a part of the outer surface of the electronic component 1. In other words, rather than an aligning structure 5 provided in the electronic component 1 specifically for the purpose of aligning the electronic component with respect to the surface 21, such as a recess or a protrusion, at least one aligning structure 5 may comprise a predetermined part of the outer surface 6 of the electronic component 1 designed to enable alignment of the electronic component 1 on the surface 21. Otherwise, such an aligning structure 5 and electronic component 1 may be similar to an embodiment or combination of embodiments disclosed in this disclosure. According to an embodiment, the circuit board 20 may be provided with aligning counter structure(s) 24, wherein the aligning counter structure(s) 24 or parts of the aligning counter structure(s) 24 comprise counter surfaces 23 conforming at least partly to the form of the respective aligning surface areas 7, 9 in such an aligning structure 5 in the electronic component 1, wherein the aligning structure 5 may be 1 designed to enable alignment of the electronic component 1 on the surface 21, when each one of the aligning surface areas 7, 9 is brought into contact with a corresponding counter surface 23.

According to an embodiment, a part of at least one aligning structure 5 may be formed as a section of a cylinder, a section of a cone, a pyramid, a section of a pyramid, a cut pyramid, a section of a cut pyramid, a section of a sphere, an ellipsoid dome, a cube, a cuboid, a prism or a cut triangular prism, and the corresponding counter surface 23 of the respective aligning counter structure 24 conforms at least partly, and preferably over the whole surface area designed to engage with the respective aligning surface area 7, 9, to this shape. It is clear for a person skilled in the art that a surface and a counter surface conforming to each other refer to a recess in a surface conforming to a protrusion in a counter surface and vice versa.

According to an embodiment, such as the embodiment of Figure 9, at least one aligning counter structure 24 may extend through the circuit board 20 in such a manner that the same counter structure 24 may also be used for aligning the circuit board 20 on an external module 25. In other words, the same aligning counter structure(s) 24 may be used to first align the electronic component 1 on the surface 21, such as on the circuit board 20, and later to align the surface 21, such as the circuit board 20, on a module 25. The module may comprise an apparatus or a part of an apparatus, wherein the electronic component 1 and the circuit board 20 are designed to be mounted to and, thus, used in for their actual purpose, such as for inertial measurements.

Figure 12 illustrates schematically a method for aligning an electronic component.

According to a method, such as the method of Figure 12, for aligning an electronic component 1, which may be an electronic component 1 according to an embodiment or combination of embodiments disclosed in this disclosure, on a surface 21 may comprise the step of providing 121 the electronic component 1 on the surface 21 in such a manner that the first aligning surface areas 7 and the second aligning surface areas 9 are provided against counter surfaces 23 fixed on the surface 21 for preventing at least a rotation of the electronic component 1 about an axis 11 perpendicular to the plane 22 defined by the surface 21.

According to an embodiment, the method may further comprise calibrating the alignment of the electronic component 1 on the surface 21. More particularly, the same aligning structure(s) 5 used in assembling the electronic component 1 on the surface 21, such as to the circuit board 20, may be used for calibrating, for instance in a calibrator. This may improve the measurement accuracy further. According to a further embodiment, the method may further comprise storing the calibration information in a memory (not shown) for later use. In such embodiments, the calibration made for the alignment of the electronic component 1 on the surface 21 may be used for calibrating the alignment of the component 1, and especially a possible axis of interest 15, with respect to the module 25 or apparatus comprising the module 25. This may enable more accurate aligning of the electronic component 1, and the axis of interest 15, with respect to a function to be monitored, and shorten the time needed for calibrating the alignment when the electronic component 1 mounted on the surface 21, for instance on the circuit board 20, is mounted to the module 25 or the apparatus. The function to be monitored may comprise for instance a measurement axis. Better accuracy of aligning the axis of interest 15 in the electronic component 1, for instance of the chip 2, with the intended measurement axis of the module 25 or the apparatus improves the actual measurement accuracy in the apparatus and enables improved quality of the apparatus, such as a more accurate control of the apparatus.

## Claims

1. An electronic component configured to be mounted on an external surface, which surface defines a plane,
the electronic component comprising
at least one electronic chip housed within package,
**characterized in that**
the electronic component is provided with one or more aligning structures, which aligning structure(s) are formed on an outer surface of the electronic component, wherein the aligning structure(s) define at least two first aligning surface areas in a first direction and at least two second aligning surface areas in a second direction, wherein the first direction and the second direction are parallel to said plane defined by the surface and perpendicular in relation to each other,
and wherein the first aligning surface areas and the second aligning surface areas are formed and spaced from each other in such a manner that at least a rotation of the electronic component about an axis perpendicular to the plane defined by the surface is prevented, when the first aligning surface areas and the second aligning surface areas are provided against counter surfaces fixed on the surface and conforming at least partly to the form of the respective aligning surface areas.

2. An electronic component according to claim 1, wherein the aligning structure(s) further define at least two third aligning surface areas in a third direction,
wherein third direction is perpendicular to the first direction and the second direction, as well as to said plane defined by the surface.

3. An electronic component according to claim 1 or 2, wherein the electronic component comprises exactly one aligning structure and wherein each one of the first aligning surface areas, the second aligning surface areas and/or the third aligning surface areas comprises a part of the outer surface of the electronic component in the area of the aligning structure.

4. An electronic component according to claim 1 or 2, wherein the electronic component comprises at least two aligning structures and wherein each one of the first aligning surface areas, the second aligning surface areas and/or the third aligning surface areas comprises in each case a part of the outer surface of one of the aligning structures.

5. An electronic component according to any one of claims 1 - 4, wherein the aligning structure(s) are provided in a part of the electronic component made from a dimension accurate material.

6. An electronic component according to claim 5, wherein the aligning structure(s) are provided in a part of the electronic component made from metal, ceramic material, or plastic material.

7. An electronic component according to any one of claims 1 - 6, wherein each aligning surface area has a precise, predetermined three-dimensional shape,
whereby the aligning surface areas form in each case a pair of aligning surface areas in the respective direction in such a manner that the electronic component can be precisely aligned in each of the directions with respect to the surface, when the aligning surface areas are provided against respective counter surfaces fixed to the surface.

8. An electronic component according to claim 7, wherein aligning the electronic component precisely comprises aligning the electronic component at an alignment inaccuracy of 0.1 degrees or less at least in the first direction and in the second direction.

9. An electronic component according to any one of claims 1 - 8, wherein at least one aligning structure is formed as a protrusion protruding from the outer surface or a recess extending from the outer surface into the electronic component.

10. An electronic component according to any one of claims 1 - 9, wherein at least one aligning structure is formed as a section of a cylinder, a section of a cone, a pyramid, a section of a pyramid, a cut pyramid, a section of a cut pyramid, a section of a sphere, an ellipsoid dome, a cube, a cuboid, a prism, or a cut triangular prism.

11. An electronic component according to any one of claims 1 - 10, wherein the electronic component comprises a cap and wherein at least one of the aligning structures is provided in the cap.

12. An electronic component according to any one of claims 1 - 11, wherein at least one of the first aligning surface areas, the second aligning surface areas or the third aligning surface areas has a three-dimensional shape.

13. An electronic component according to any one of claims 1 - 12, wherein the electronic chip is orientation-sensitive.

14. An electronic component according to claim 13, wherein the orientation-sensitive electronic chip comprises an axis of interest, and wherein the aligning surface areas are configured to align at least the axis of interest with respect to the surface.

15. An electronic component according to claim 13 or 14, wherein the electronic chip comprises at least one of the following: an accelerometer configured to measure acceleration, a gyroscope configured to measure angular rotation, or a magnetometer.

16. An electronic component according to any one of claims 1 - 15, wherein
the one or more aligning structures provided in the electronic component define at least two aligning surface areas in the direction of each one of the three dimensions in such a manner that they enable aligning the electronic component to in all three dimensions with respect to the surface comprising respective counter surfaces.

17. A circuit board, **characterized in that**
the circuit board is configured to receive an electronic component according to any one of claims 1-16,
that the surface of the circuit board configured to receive the electronic component defines the plane, and
that the surface is provided with at least one aligning counter structure, which aligning counter structure(s) or parts of the aligning counter structure(s) comprise counter surfaces conforming at least partly to the form of the respective aligning surface areas in the electronic component for aligning the electronic component on the circuit board.

18. A circuit board according to claim 17, wherein the aligning structure is part of the outer surface of the electronic component.

19. A circuit board according to claim 17 or 18, wherein at least one aligning counter structure extends through the circuit board in such a manner that the same counter structure may also be used for aligning the circuit board on an external module

20. A method for aligning an electronic component according to any one of claims 1-16 on a surface, **characterized in that** the method comprises the step of providing the electronic component on the surface in such a manner that the first aligning surface areas and the second aligning surface areas are provided against counter surfaces fixed on the surface for preventing at least a rotation of the electronic component about an axis perpendicular to the plane defined by the surface.

21. A method according to claim 20, wherein the method further comprises calibrating the alignment of the electronic component on the surface, and storing the calibration information in a memory for later use.
